# EUROPEAN PATENT APPLICATION

(11) **EP 4 797 316 A1**
(43) Date of publication of application: **26.08.2026**
(21) Application number: 25159212.7
(22) Date of filing: 20.02.2025
(51) Int. Cl.: H01L 21/033, H01L 21/308, H01L 21/311

(54) **A METHOD FOR PRODUCING ELONGATE PATTERN FEATURES BY APPLYING DIRECTIONAL ETCHING**

(71) Applicant: Imec VZW, 3001 Leuven (BE)
(72) Inventor: Lazzarino, Frederic, 1320 Hamme-Mille (BE); Blanco, Victor M., 3061 Leefdaal (BE)
(74) Representative: Patent Department IMEC

(57) **Abstract**

A stack of alternatingly applied etch stop layers (27) and mask layers (28) is produced on a target layer (25) present on a support substrate (26). The target layer is to be patterned according to a pattern comprising parallel line features (34,34'). The top mask layer is patterned according to a pattern of openings (30) and thereafter these openings are elongated by directional etching relative to the etch stop layer, to form a pattern of elongated openings (31,31'). This pattern is transferred to the subsequent mask layer (28) and in said subsequent mask layer, the elongated openings are further elongated by directional etching. This sequence is repeated down to the bottom mask layer. In said bottom mask layer, the pattern of openings has been elongated to a set of lines (34,34'), which are then transferred to the target layer. By repeating the elongation process a number of times, the obtainable elongation is increased compared to a process wherein only one directional etch step is applied.

## Description

### Field of the Invention

The present invention is related to semiconductor fabrication processes, in particular to patterning methods applicable for realizing nanometre-sized features in a patterned layer.

### State of the art.

Semiconductor fabrication processing relies on advanced lithography and etch technologies capable of realizing patterns at the nanometre-sized scale required in the front-end-of-line and at the deepest levels of the back-end-of-line process sequences. Nevertheless, even the most advanced EUV lithography tools are limited in terms of the obtainable resolution, requiring expensive multiple exposure methods for printing features smaller than the resolution limit.

Directional patterning techniques represent a promising way of overcoming these limitations. The term `directional patterning' encompasses directional etching and directional deposition.

Basic principles and configurations for realizing directional patterning are for example described in patent publication document US10790155. According to the technology, a plasma beam is scanned relative to a substrate comprising a layer that is to be patterned. By tuning several parameters and conditions, it is possible to direct a plasma beam containing etch species so that the beam etches a layer on the wafer at a considerably higher etch rate in the scanning direction than in directions orthogonal to said scanning direction. This capability makes it possible to 'stretch' an existing opening in the layer by scanning a plasma beam across the opening.

Directional etching thereby enables patterning line features at sub-resolution pitch. Starting from a pattern of openings obtainable by anisotropic etching and taking advantage of a judicious arrangement of the openings, the openings are stretched so as to obtain lines at the required sub-resolution pitch. This approach is also described in US10790155.

One problem related to directional etching is that the etch rate in the direction perpendicular to the support substrate is not zero and causes thinning of the layer patterned by the directional etching process. This aspect limits the obtainable elongation and makes it difficult to obtain line features above a given length.

### Summary of the invention

The invention is related to methods in accordance with the appended claims. According to the invention, a stack of alternatingly applied etch stop layers and mask layers is produced on a target layer present on a support substrate. The target layer is to be patterned according to a pattern comprising parallel line features. The top mask layer is patterned according to a pattern of openings and thereafter these openings are elongated by directional etching relative to the etch stop layer, to form a pattern of elongated openings. This pattern is transferred to the subsequent mask layer and in said subsequent mask layer, the elongated openings are further elongated by directional etching. This sequence is repeated down to the bottom mask layer. In said bottom mask layer, the pattern of openings has been elongated to a set of lines, which are then transferred to the target layer.

By repeating the elongation process a number of times, the obtainable elongation is increased compared to a process wherein only one directional etch step is applied. The method is applicable for small dimensions and the directional etching enables forming line features at subresolution pitch. The method applies this capability of directional etching and enables the creation of longer line features compared to existing methods.

According to an embodiment, the openings of the initial patten or of any of the intermediate patterns of elongated openings are subjected to a shrinking step before transferring the pattern to the subsequent mask layer. This further improves the obtainable pitch as it enables to compensate the effect of the non-zero lateral etch rate during directional etching.

The invention is in particular related to a method for producing a pattern comprising line-shaped features on a support substrate, by patterning a mask layer in accordance with said pattern and transferring the pattern from the mask layer to a target layer present on the support substrate, the method comprising the steps of :
- producing a first pair of an etch stop layer and a mask layer on the target layer,
- producing at least one further pair of an etch stop layer and a mask layer on the first pair, so as to obtain a stack of alternatingly arranged etch stop layers and mask layers,
- patterning the top mask layer of the stack according to a predefined pattern of openings,
- in the top mask layer, elongating the openings of the pattern by directional etching selectively relative to the top etch stop layer, whereby the top mask layer is thinned from an initial thickness to a remaining thickness,
- using the thinned top mask layer to transfer the pattern of elongated openings to the subsequent mask layer,
- in said subsequent mask layer, further elongating the elongated openings by directional etching, whereby said subsequent mask layer is thinned from an initial thickness to a remaining thickness,
- performing the two preceding steps repeatedly from the top of the stack to the bottom, until the openings are elongated to such a degree that a line pattern is formed in the bottom mask layer of the stack,
- transferring said line pattern to the target layer.

According to an embodiment, the method further comprises one or more steps of shrinking the openings of the initial pattern of openings in the top mask layer or of one or more patterns of elongated openings in one or more subsequent mask layers of the stack, said one or more shrinking steps being performed before the respective directional etching steps performed on the respective mask layers of the stack.

According to an embodiment, each mask layer comprises a stack of sublayers, comprising from bottom to top :
- a first hardmask layer of a thickness t1,
- a second hardmask layer of a thickness higher than t1,
- a third hardmask layer of a thickness essentially equal to t1.
and wherein the third hardmask layer is consumed during patterning of the top mask layer and during the transfer of one of the patterns of elongated openings to a subsequent mask layer, so that the directional etching steps are performed on a stack formed of the first and second hardmask layers.

### Brief description of the figures

Figure 1 illustrates the main components of a tool suitable for directional etching.
Figures 2a and 2b illustrate the process of directional etching.
Figures 3 to 13 illustrate a process sequence applicable in a method according to an embodiment of the invention.
Figures 14 to 25 illustrate a process sequence according to a second embodiment of the invention.

### Detailed description of the invention

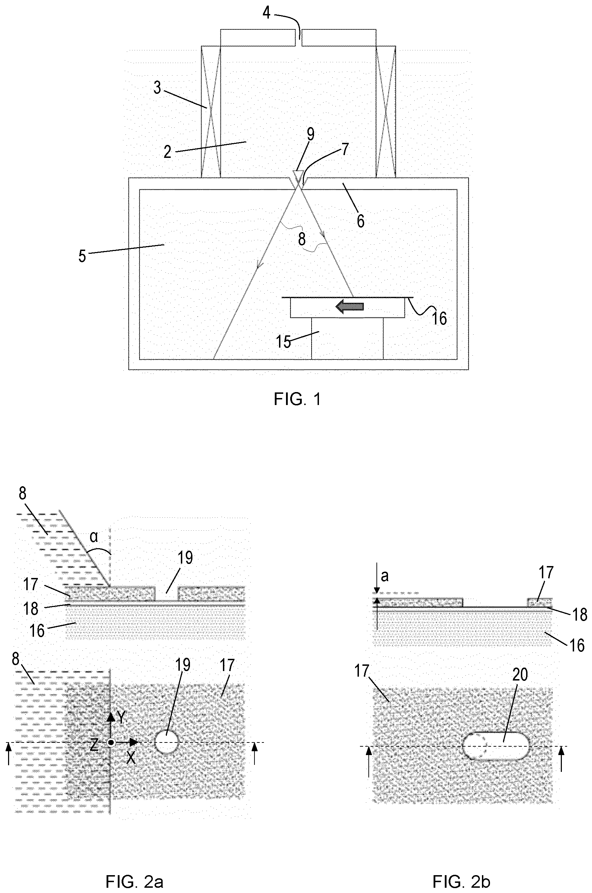

Figure 1 illustrates a process tool 1 for applying one particular directional etching technology that is presently known in the state of the art. The invention is however not limited to this technology. The tool comprises a plasma chamber 2 surrounded by an RF coil 3 for generating a plasma in the chamber. A gas inlet 4 enables supplying a gaseous substance, while the overall pressure in the plasma chamber is kept at very low to vacuum level by a suitable vacuum pump installation (not shown). The plasma chamber 2 is separated from a process chamber 5 by a separating wall 6 comprising a slit 7, so that ribbon plasma beams 8 are emitted from the slit. The process chamber is also at low to vacuum pressure. A meniscus 9 may be mounted in the vicinity of the slit 7 at a distance that can be set in order to control the propagation direction of the emitted beams 8. A wafer stage 15 is mounted in the process chamber 5. The wafer stage 15 is movable linearly as indicated by the arrow, so that a wafer 16 held by the wafer stage can be moved relative to one of the beams 8, thereby creating the equivalent of the beam 8 being scanned across the wafer 16.

As stated, other directional etching technologies are known and can be applied in the method according to the invention. Ion beam-based technologies include a method wherein a collimated beam of charged particles e.g. Ar⁺ is accelerated on a full wafer at a given angle of incidence. In the latter method, the wafer stage is not moving relative to the beam as the beam is impinging on the full wafer. According to another known ion beam-based technology, a collimated beam of ionized gas clusters is accelerated to a spot and scanned across a wafer surface at a given angle of incidence. In the latter two technologies, the angle of incidence of the beam is adjusted by tilting the wafer.

Figures 2a and 2b illustrate the directional etching effect on a layer 17 formed on the wafer 16. The layer 17 is produced on an etch stop layer 18. Before applying the directional etch process, an opening 19 is formed in the layer 17 by standard lithography and etching, for example by direct ion etching (DIE). A plasma beam 8 is generated and directed at an angle of incidence a, defined as the angle between the beam 8 and the direction perpendicular to the surface of the layer 17. By moving the wafer stage 15 in the direction indicated in Figure 1, the plasma beam 8 is scanned relative to the layer 17 in a scanning direction X. The angle β between the beam 8 and the scanning direction X is an oblique angle equal to 90°+a. By applying a suitable combination of etch parameters such as the RF power, a DC bias voltage connected to the separator plate 6 and/or the wafer stage 15, the applied etch species, the angle of incidence a and the scanning speed, scanning the beam across the opening 19 has the effect of stretching the opening in the scanning direction, as illustrated in Figure 2b. The directional etch process is selective with respect to the etch stop layer 18 so that this layer remains essentially intact and prohibits etching of the underlying support substrate 16. The etch rate in the X-direction is considerably higher than the etch rate in the Y and Z-directions. The result is therefore an elongation of the opening 19 in the X-direction to form a line-shaped trench 20. In the Y-direction the line is slightly larger than the original diameter of the openings, due to the non-zero etch rate in the Y direction. Etching in the Z-direction causes thinning of the layer 17 by a layer thickness reduction a.

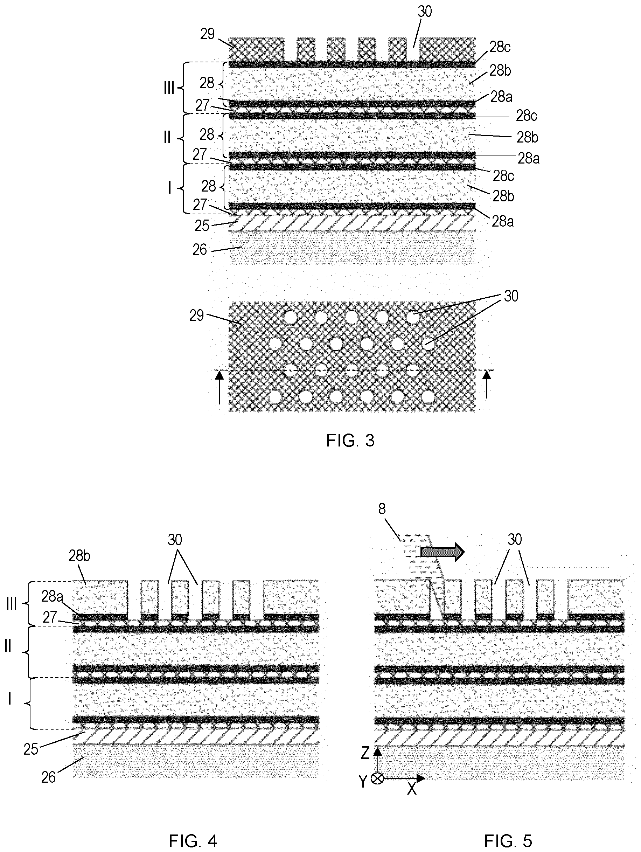

The method according to a first embodiment of the invention is illustrated in Figures 3 to 13. The aim is to pattern a target layer 25 formed on a support substrate 26. The target layer 25 may be any layer that needs to be patterned in the course of a semiconductor fabrication process, for example a dielectric layer formed in the course of the back end of line fabrication of integrated circuits produced on a silicon process wafer, wherein the dielectric layer needs to be patterned by creating parallel line-shaped trenches at a regular pitch, to be filled thereafter with metal to form conductive paths. The invention is however not limited to any type of layer that is be patterned, nor to any particular stage within a semiconductor fabrication process.

With reference to Figure 3 : on top of the target layer 25, a stack of several layers is produced. In direct contact with the target layer 25, a first etch stop layer 27 is formed, followed by a mask layer 28 comprising three sublayers : a bottom hardmask layer 28a, a middle hardmask layer 28b and a top hardmask layer 28c. A mask layer is defined within the present context as any layer configured to be patterned according to a given pattern whereafter the pattern is transferred to a layer lying underneath the mask layer. Transferring a pattern from a patterned mask layer to an underlying layer is defined within the present context as etching the underlying layer by an etch process that reproduces the mask pattern in the underlying layer. In the case of transferring a mask pattern to the target layer 25, this includes embodiments wherein a tone reversal is performed before actually transferring the pattern, i.e. negative features (openings and trenches) are transformed to positive features (islands and lines) : for example if the mask layer is pattern of trenches, the trenches may be filled with a material followed by the removal of the mask material, so that positive lines remain. These lines are then transferred to the target layer 25.

The stack of hardmask layers 28a-28c is one possible embodiment of a 'mask layer' referred to in the appended claims. A mask layer may have other physical appearances within the wider scope of the invention. It may be a single layer, for example a layer of photoresist. The three-sublayer stack 28a-28c may be used to produce very small features, having dimensions in the order of nanometers. The invention is however not limited to any particular dimensions of the patterned features produced by the method of the invention.

The etch stop layer material 27 may depend on the hard mask stack material combination but can be a metal-based material (for example Ti, TiN, TiO₂, TiON, Ta, TaN... ), an aluminium-based dielectric material, or a Si-based material like amorphous Si. The bottom hardmask layer material 28a depends on the hard mask stack material combination but can be a dielectric material used in semiconductor fabrication like Spin on glass, SiOC, SiO₂, SiN, SiON, SiCN, SiOCN, SiC, or a metal-based material (for example Ti, TiN, TiO₂, TiON, Ta, TaN... ) or an aluminium-based dielectric material. The middle hardmask layer 28b can for example be an organic carbon-containing layer like amorphous carbon, Diamond like Carbon (DLC) or Spin on Carbon (SOC). The top hardmask layer 28c can be the same material as the bottom layer 28a or formed of one of the materials cited as possible materials for the bottom layer. The thickness of the top and bottom layers is preferably the same and smaller than the thickness of the middle layer. In the particular non-limiting embodiment illustrated in the drawings, the thickness of the top and bottom hardmask layers 28a,28c may be in the order of 10-15nm while the thickness of the middle layer 28b may be in the order of 50-100 nm.

The etch stop layer 27 and the mask layer 28 formed directly on the target layer 25 represent a first `etch stop/mask combination' I. Two further etch stop/mask combinations II and III are formed on top of the first combination I, each of the additional combinations comprising an etch stop layer 27 and a mask layer 28 comprising the three sublayers 28a-28c as described above. On top of the stack of the three etch stop/mask combinations I, II, III, a resist layer 29 is formed and patterned by standard lithography according to a pattern of openings. The pattern is a regular array of circular openings 30 of equal diameter. In the case shown the pattern is a hexagonal pattern, i.e. each opening 30 is surrounded by six other openings at regular angular and linear distances from the central opening. The invention is however not limited to any particular pattern of openings, regular or irregular. By way of example, the openings may have a diameter of about 20 nm, with the center-to-center pitch of the array (distance between the centers of each pair of adjacent openings) about 46 nm.

The pattern of openings 30 is transferred to the mask layer 28 of the upper etch stop/mask combination III. This may be done by first etching the top mask layer 28c relative to the resist 29 using a first etch recipe. Then the middle hardmask layer 28b is etched using a second etch recipe that also etches the resist 29. The resist is therefore consumed as the openings 30 are etched in the middle hardmask layer 28b. Then the bottom hardmask layer 28a is etched by a third etch recipe, while simultaneously the top hardmask layer 28c is consumed. The result is shown in Figure 4 : the pattern of openings 30 has been transferred to the bottom hardmask layer 28a and the middle hardmask layer 28b of the upper etch stop/mask combination **III.**

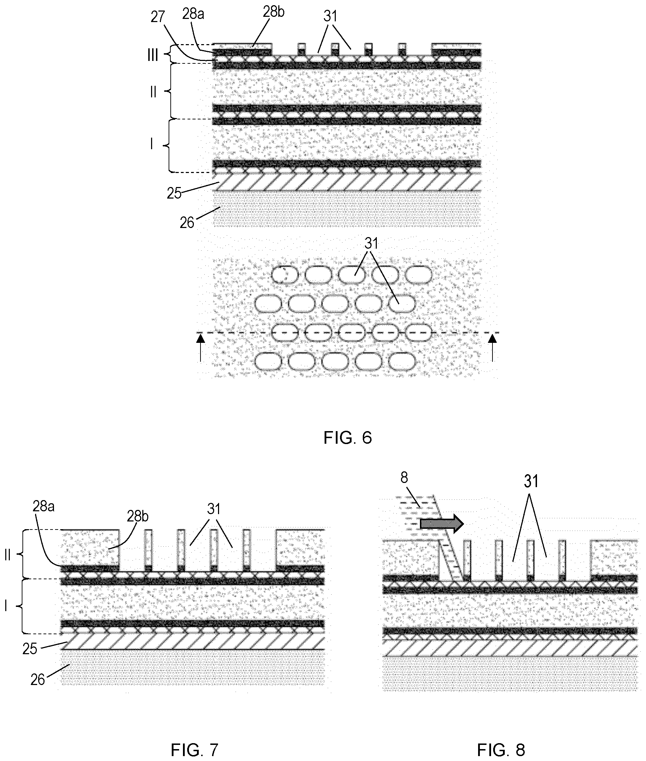

At this point, the hardmask layers 28a and 28b of the upper combination **III** are subjected to a directional etch step as described above, and as illustrated in Figure 5. The directional etch beam 8 is scanned in the X-direction across the pattern of openings, thereby etching layers 28a and 28b of the upper etch stop/mask combination III selectively with respect to the etch stop layer 27 of that combination III. After the passage of the beam, the openings are enlarged as shown in Figure 6. The middle hardmask layer 28b has been thinned by the directional etch process, i.e. the original mask layer 28 is thinned : layer 28a and a thinned remaining portion of layer 28b are left after the passage of the directional etch beam 8. The directional etch process has elongated the openings 30 to form a pattern of line portions 31 in the thinned mask layer.

With reference to Figure 7, the pattern of line portions 31 is transferred by anisotropic etching to the underlying etch stop layer 27 of the upper etch stop/mask combination III and thereafter to the hardmask sublayers 28a-28c of the second etch stop/mask combination II. When the line portions have been transferred to the etch stop layer 27 of the upper etch stop/mask combination, said etch stop layer 27 acts as a mask to open layer 28c. Said etch stop layer is then preferably removed selectively with respect to the underlying layers. Therefafter, the top hardmask layer 28c of the second combination is used as a mask to etch through layer 28b, and said layer 28c is then consumed while etching through the bottom layer 28a, resulting in the image shown in Figure 7 : the line portions 31 are transferred in the form of trenches 31 through the layers 28a and 28b of the second etch stop/mask combination II. The etch sequence described hereabove is applicable to the specific configuration of sublayers which constitute the mask layer 28 in the illustrated embodiment. The invention is not limited to said configuration and the etch sequence can be different from the one described above.

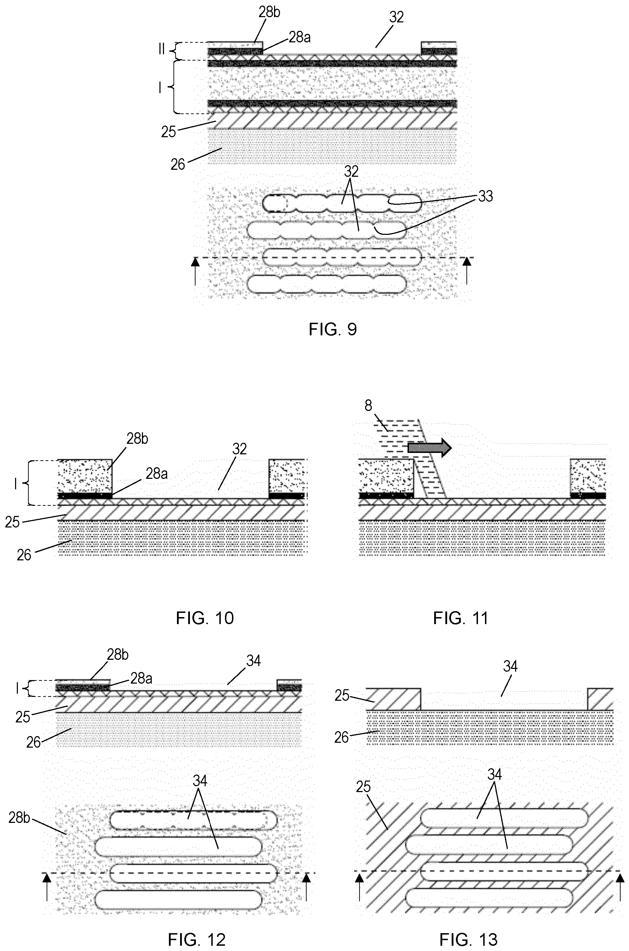

This is followed by a second directional etch step illustrated in Figure 8, with the result thereof shown in Figure 9. The line portions 31 are further stretched and merge to form continuous trenches 32. However the sidewalls of the trenches still show protrusions 33 of the merged line portions. The mask layer 28 of the second etch stop/mask combination II is thinned, i.e. layer 28a and a thinned layer 28b remain after the second directional etch step.

With reference to Figure 10, the pattern of trenches 32 including the protrusions 33, is transferred to the hardmask layers 28a and 28b of the lower etch stop/mask combination I. Thereafter, by a last directional etch process illustrated in Figures 11 and 12, the remaining protrusions 33 of the merged line portions are removed, and the trenches are further elongated, to form final trenches 34. The last directional etch step has thinned the mask layer 28 of the lower etch stop/mask combination I.

The final line pattern is then transferred to the target layer 25, as illustrated in Figure 13. Any remaining portions of the lower etch stop/mask combination I may be stripped after the pattern transfer to the target layer 25. As stated, a tone reversal could be applied before transferring the pattern to the target layer.

By the sequence of directional etch steps, each time followed by transferring the elongated pattern features to the underlying mask layer and eventually to the target layer, the initial patten of openings 30 is stretched to a line pattern 34, whereas a single directional etch step would only have elongated the openings to separate line-shaped features 31. By producing multiple etch stop/mask combinations, it therefore becomes possible to produce more elongated features.

If a pattern of openings of smaller pitch is used as the starting point however, the above-described sequence may not be able to result in a pattern of separate parallel lines. As stated above, directional etching in the X-direction also causes some etching in the Y-direction, i.e. openings and lines are not only elongated in the X-direction but the lines also become a little broader in the Y-direction. For the exemplary pattern applied in the above-described sequence, the initial center-to-center pitch is about 46 nm and the diameter of the openings about 20 nm, which enables the eventual result shown in Figure 12, i.e. a set of separate lines 34.

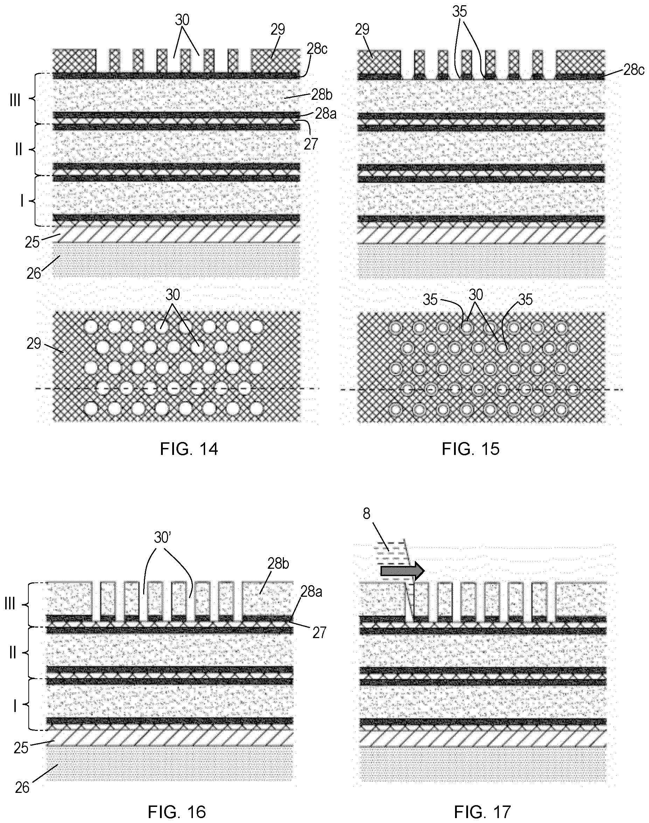

Figure 14 shows the same starting condition as in the previous sequence, but now the center-to-center pitch is reduced to about 36 nm for the same diameter of the openings of about 20 nm. By applying the same sequence, the eventual lines 34 are likely to be too close together and they could merge to form one continuous open area, which is not the desired result.

To remedy this, a shrinking step is added to the sequence. In Figure 15 it is illustrated that the shrinking step is applied at the start of the sequence, but it can also be applied later in the process, or multiple shrinking steps can be applied.

Shrinking an opening in a layer is a process that is known as such, and various ways of realizing it may be applied within the scope of the invention. One possibility is to apply reactive ion etching wherein the etch species is configured to etch openings through a layer but at the same time deposit a polymer on the sidewalls of the thus created openings in the layer. This is applied in the case illustrated in Figure 15 : using the openings 30 in the resist layer as the mask, openings are etched through the top hardmask layer 28c of the upper etch stop/mask combination III, and sloped polymer portions 35 are formed on the sidewalls of the thus created openings in said layer 28c. The slope of the polymer portions 35 determines the degree of shrinking. In the case shown, the diameter of the openings is reduced from about 20 nm to about 10 nm.

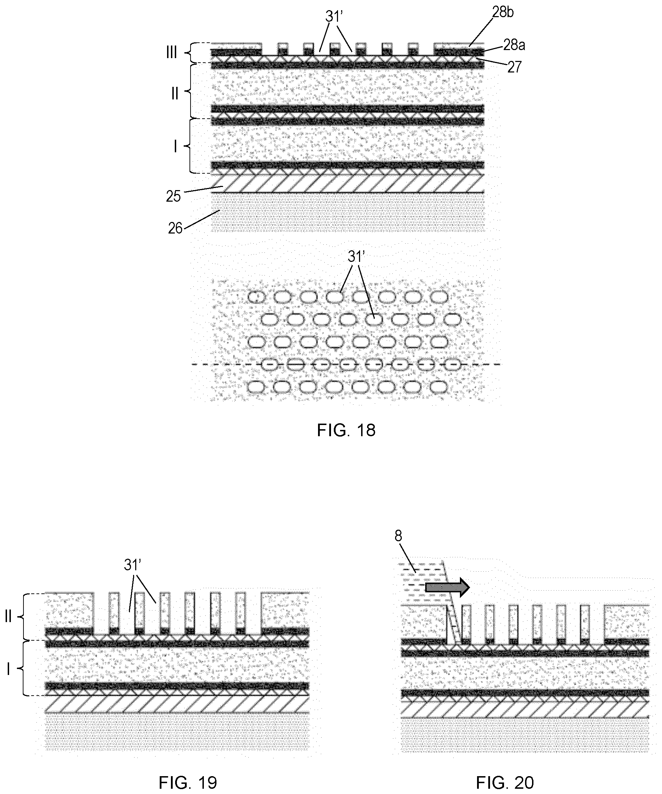

The reduced diameter is then transferred to the layers 28b and 28a of the upper etch stop/mask combination III, as shown in Figure 16, creating openings 30' of reduced diameter in the layers 28a and 28b of the upper etch stop/mask combination III. Then the first directional etch step is applied, as illustrated in Figures 17 and 18, creating elongated line portions 31'.

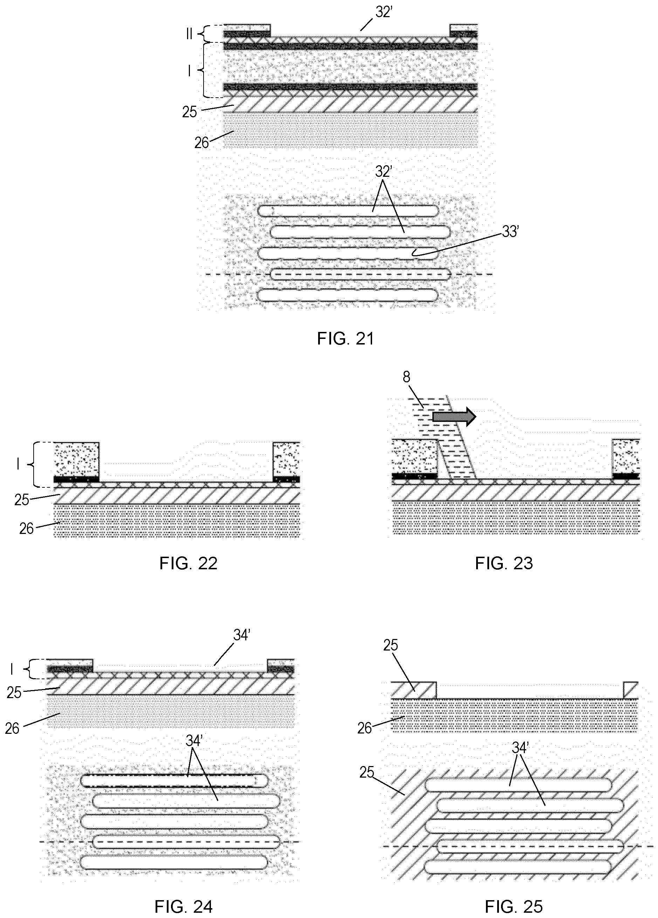

Thereafter, the same process steps are performed as in the previously described sequence : transferring the elongated line portions 31' to the second etch stop/mask combination II (Figure 19), directional etching to form trenches 32' having protrusions 33' (Figures 20 and 21), transferring said trenches to the lower etch stop/mask combination I (Figure 22), directional etching to form final trenches 34' (Figures 23 and 24), and finally transferring the final trenches to the target layer 25 (Figure 25). Due to the initial shrinking step, the final trenches are distanced from each other.

As stated, the shrinking step could also be performed later in the process sequence. It could be performed after any of the transferring steps of elongated openings or trenches to the underlying next mask layer. Shrinking is then applied to previously elongated openings or trenches before subjecting the shrunk elongated openings or trenches to the next directional etch step. If necessary, several shrinking steps could be applied, potentially after every transfer of openings or trenches to the next mask layer and before every directional etch step.

The invention is not limited to a method wherein three etch stop/mask combinations are used. The number of etch stop/mask combinations can be any realistically applicable number.

## Claims

1. A method for producing a pattern comprising line-shaped features (34,34') on a support substrate (26), by patterning a mask layer (28) in accordance with said pattern and transferring the pattern from the mask layer to a target layer (25) present on the support substrate (26), the method comprising the steps of :
- producing a first pair of an etch stop layer (27) and a mask layer (28) on the target layer (25),
- producing at least one further pair of an etch stop layer (27) and a mask layer (28) on the first pair, so as to obtain a stack of alternatingly arranged etch stop layers (27) and mask layers (28),
- patterning the top mask layer (28) of the stack according to a predefined pattern of openings (30),
- in the top mask layer (28), elongating the openings (30) of the pattern by directional etching selectively relative to the top etch stop layer (27), whereby the top mask layer (28) is thinned from an initial thickness to a remaining thickness,
- using the thinned top mask layer to transfer the pattern of elongated openings (31,31') to the subsequent mask layer (28),
- in said subsequent mask layer, further elongating the elongated openings by directional etching, whereby said subsequent mask layer is thinned from an initial thickness to a remaining thickness,
- performing the two preceding steps repeatedly from the top of the stack to the bottom, until the openings (30) are elongated to such a degree that a line pattern (34,34') is formed in the bottom mask layer (28) of the stack,
- transferring said line pattern to the target layer (25).

2. The method according to claim 1, further comprising one or more steps of shrinking the openings (30) of the initial pattern of openings in the top mask layer (28) or of one or more patterns (31,32) of elongated openings in one or more subsequent mask layers of the stack, said one or more shrinking steps being performed before the respective directional etching steps performed on the respective mask layers (28) of the stack.

3. The method according to claim 1 or 2, wherein each mask layer (28) comprises a stack of sublayers, comprising from bottom to top :
- a first hardmask layer (28a) of a thickness t1,
- a second hardmask layer (28b) of a thickness higher than t1,
- a third hardmask layer (28c) of a thickness essentially equal to t1.
and wherein the third hardmask layer (28c) is consumed during patterning of the top mask layer and during the transfer of one of the patterns of elongated openings to a subsequent mask layer, so that the directional etching steps are performed on a stack formed of the first and second hardmask layers (28a,28b).
